# EUROPEAN PATENT APPLICATION

(11) **EP 2 665 091 A2**
(43) Date of publication of application: **20.11.2013**
(21) Application number: 12194303.9
(22) Date of filing: 26.11.2012
(51) Int. Cl.: H01L 21/67

(54) **Equipment for substrate surface treatment**

(30) Priority: 16.05.2012 TW 101117380
(71) Applicant: Kern Energy Enterprise Co., Ltd., Taipei City 110 (TW)
(72) Inventor: Hsiao, Ying-Shih, Taipei City 110 (TW)
(74) Representative: Lang, Christian

(57) **Abstract**

A substrate surface treatment equipment includes a chamber, a ultraviolet ray lamp, an infrared heating element, a blackbody radiation plate and a vacuum extractor. The equipment can do the substrate surface treatment. The substrate surface treatment equipment can wash or modify the substrate surface. Therefore, after the washing and modifying of the substrate surface, the substrate surface can include a better adhesion when processing a thin film deposition or a colloid suspension coating.

## Description

### BACKGROUND OF THE INVENTION

### 1. Field of the Invention

The present invention is related to substrate surface treatment equipment, and more particularly related to substrate surface treatment equipment made by an ultraviolet lamp and a blackbody irradiation board and configured to wash and modify the surface of the substrate to improve the adhesive quality of the substrate. Therefore, the substrate surface treatment can be implemented in the manufacturing process of the substrate surface cleaning or improvement of surface characteristics before the vacuum deposition process on the substrate or the process before the colloid suspension coating.

### 2. Description of the Prior Art

In the present semiconductor manufacturing technique, most of the manufacturing processes are required to use a substrate. However, the surface of the substrate would have some polluted materials during the manufacturing process or the transportation process. If the polluted materials are not eliminated on the surface of the substrate, the yield rate would reduce. For example, when the clean class on the surface of the substrate is not good enough, the optical components would be damaged or the circuit would have some drawbacks to decrease the manufacturing yield rate. Especially, when the size of the semiconductor is become smaller and smaller, the pollution washing of the surface or the control of the surface property is more and more important. In order to include a better cleaning class of the surface, the washing or modifying process on the surface of the substrate can be processed first before the manufacturing process on the substrate. The pollution on the surface of the substrate can be eliminated by surface cleaning or improvement of surface characteristics. The determination of the clean class on the surface is to measure the contact angle of the water on the substrate. For example, when determining the clean class of the surface of the substrate, the water is dropped on the substrate or the surface of the substrate to measure the contact angle on the substrate without surface treatment and with surface treatment. When the measured contact angle is smaller, the clean class on the substrate or the surface of the substrate is better so as to increase the yield rate of the following manufacturing processes.

Now, there are many different methods to do the substrate surface treatment, such as plasma treatment, corona discharge, dielectric barrier discharge (DBD) and so on.

Such as plasma treatment, because plasma is not solid, liquid or gas state and called the fourth state. The gas is ionized at high electromagnetic field to form active gas, such as negative electron, positive and negative ions and free radical. The plasma is used to clean and treat the surface of the substrate. The plasma treatment is required to include high energy and the surface of the substrate would be damaged during the cleaning and treatment process.

Besides, corona discharge treatment used to wash and clean the surface of the substrate is to implement a high electric field to ionize a liquid. For example, air is ionized in high electric field, and some molecules with ionized condition are generated near the electric field. The ionized molecules will be reacted with some other metastable molecules to wash ad modify the surface of the substrate. However, the drawback of the corona discharge treatment is the low process efficiency and the electric field is easy to be destroyed.

When DBD treatment is used to wash and modify the surface of the substrate, the DBD includes at least one dielectric material, such as quartz, between two electrodes. By connecting to high current and voltage level, the gas between the two electrodes is activated to decompose so as to wash and modify the surface of the substrate. However, the drawback of the method is the current is gathered in some small points to damage the material of the surface treatment on the electrode.

### SUMMARY OF THE INVENTION

In order to solve the problems above, one object of the present invention is to provide a substrate surface treatment equipment to wash the surface of the substrate. Therefore, the surface of the substrate, which is washed, includes a better clean condition.

Another object of the present invention is to provide substrate surface treatment equipment to treat the surface of the substrate. Therefore, the treated surface of the substrate includes a better adhesive property so as to be applied to the process of film deposition on substrate in vacuum.

According object above, the present invention provides substrate surface treatment equipment includes a chamber, at least one ultraviolet lamp, an infrared heating element and a blackbody irradiation board. An inner space of the chamber includes a top end and a bottom end, and the top end is opposite to the bottom end and a containing space is formed between the top end and the bottom end. The at least one ultraviolet (UV) lamp is disposed on a bottom of the top end. The infrared heating element is disposed on a top of the bottom end. The blackbody irradiation board is disposed within the containing space of the chamber and disposed between the UV lamp and the infrared heating element.

One another object of the present invention is to provide substrate surface treatment equipment to include a roller system with plurality of rolling wheel for substrate transportation of in-line manufacturing.

According to object above, the present invention provides substrate surface treatment equipment includes a chamber, at least one ultraviolet lamp, an infrared heating element and a plurality of blackbody irradiation components. The inner space of the chamber includes a top end and a bottom end, and the top end is opposite to the bottom end and a containing space is formed between the top end and the bottom end. The at least one ultraviolet (UV) lamp is disposed on a bottom of the top end. The infrared heating element is disposed on a top of the bottom end. The blackbody irradiation components is disposed within the containing space of the chamber and disposed between the UV lamp and the infrared heating element. The blackbody irradiation components are made by a plurality of rolling wheels and a blackbody irradiation material covered on the outer surface of the rolling wheels.

One another object of the present invention is to provide a vacuum thin film deposition system. The vacuum thin film deposition system is connected the substrate surface treatment equipment to form a continuing process apparatus.

According to object above, the present invention provides a vacuum thin film deposition system is made by a substrate surface treatment equipment connecting to a vacuum thin film deposition apparatus, wherein the substrate surface treatment equipment includes a chamber, at least one ultraviolet (UV) lamp, an infrared heating element and a blackbody irradiation board. The inner space of the chamber includes a top end and a bottom end, and the top end is opposite to the bottom end and a containing space is formed between the top end and the bottom end. The at least one ultraviolet (UV) lamp is disposed on a bottom of the top end. The infrared heating element is disposed on a top of the bottom end. The blackbody irradiation board is disposed within the containing space of the chamber and disposed between the UV lamp and the infrared heating element.

One another object of the present invention is to provide a substrate surface coating system. The substrate surface coating system is connected the substrate surface treatment equipment to form a continuing process apparatus.

According to object above, the present invention provides a substrate surface coating system is made by a substrate surface treatment equipment connecting to a substrate surface coating apparatus, wherein the substrate surface treatment equipment includes a chamber, at least one ultraviolet (UV) lamp, an infrared heating element and a blackbody irradiation board. The inner space of the chamber includes a top end and a bottom end, and the top end is opposite to the bottom end and a containing space is formed between the top end and the bottom end. The at least one ultraviolet (UV) lamp is disposed on a bottom of the top end. The infrared heating element is disposed on a top of the bottom end. The blackbody irradiation board is disposed within the containing space of the chamber and disposed between the UV lamp and the infrared heating element.

### BRIEF DESCRIPTION OF THE DRAWINGS

The foregoing aspects and many of the attendant advantages of this invention will become more readily appreciated as the same becomes better understood by reference to the following detailed description, when taken in conjunction with the accompanying drawings, wherein:
FIG. 1 is a view illustrating a substrate surface treatment equipment in the present invention;
FIG. 2 is a view illustrating an operation of the substrate surface treatment equipment in the present invention;
FIG. 3 is a view illustrating a truss in an embodiment of the present invention;
FIG. 4A is a view illustrating another embodiment of the substrate surface treatment equipment in the present invention.
FIG. 4B is a view illustrating an operation of the substrate surface treatment equipment in the present invention;
FIG. 5 is another embodiment of the substrate surface treatment equipment in the present invention;
FIG. 6 is a view illustrating a vacuum thin film deposition system in the present invention; and
FIG. 7 is a view illustrating the substrate surface coating system in the present invention.

### DESCRIPTION OF THE PREFERRED EMBODIMENT

The present invention is to disclose a substrate surface treatment equipment and implements the present techniques, such as an ultraviolet lamp, a vacuum extractor, a robot fork transportation to achieve the process. Therefore, some of the detail descriptions thereof are omitted in the following chapters.

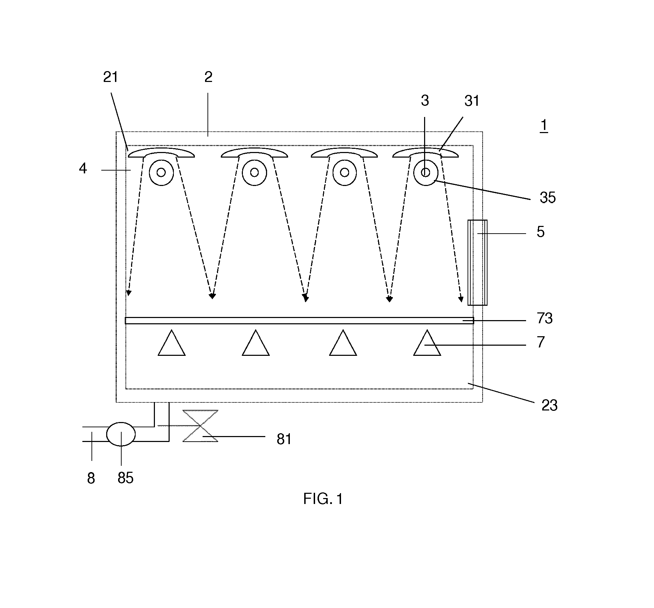

At first, please refer to FIG. 1, which is a view illustrating a substrate surface treatment equipment in the present invention. As shown in FIG. 1, the substrate surface treatment equipment in the present invention includes a chamber 2, a gate 5 and at least one ultraviolet lamp 3. The chamber 2 includes a top end 21 and a bottom end 23 and the top end 21 and the bottom end 23 are formed a capacity space 4 contacted with outer atmosphere. The gate 5 is disposed at one side of the chamber 2 and the capacity space 4 within the chamber 2 can contact with outer atmosphere when the gate 5 is opened. The ultraviolet lamp 3 is disposed within the capacity space 4 and close to the top end 21 of the chamber 2. The light source of the ultraviolet lamp 3 is made by an Excimer Ultraviolet. The ultraviolet lamp 3 is covered by a quartz tube 35 and the quartz tube 35 is covered by a reflected shield 31 with curved surface. Therefore, the ultraviolet rays can be evenly transmitted to the bottom end 23 of the chamber 2. An infrared heating element 7 is disposed within the capacity space 4 and close to the bottom end 23 of the chamber 4. Therefore, a manufacturing space is formed between the ultraviolet lamp 3 and the infrared heating element 7. The infrared heating element 7 is a rapid thermal processing (RTP) apparatus and can exactly increase the temperature to a predetermined temperature in a very short time and control the temperature to keep the temperature in a predetermined range. A blackbody irradiation board 73 is disposed within the capacity space 4 and close to one side of the infrared heating element 7. The blackbody irradiation board 73 is configured to absorb the heat generated by the infrared heating element 7 and the temperature of the blackbody irradiation board 73 is increased. Thereafter, when the temperature of the blackbody irradiation board 73 is increased, and before the temperature of the blackbody irradiation board 73 is 350°C, the high thermal conductive efficiency of the blackbody irradiation board 73 can evenly increase the heat on the substrate 71. When the temperature of the blackbody irradiation board 73 is more than 350°C, the blackbody irradiation board 73 will irradiate the heat irradiation of the far infrared rays so as to heat the bottom of the object on the blackbody irradiation board 73. The blackbody irradiation board 73 is made by graphite or carbon composites. In addition, the blackbody irradiation board 73 can be formed by covering a blackbody irradiation material on a metal board and the blackbody irradiation material is made by graphite or carbon composites. A vacuum extractor 8 is disposed in outside of the chamber 2 and connected to the capacity space 4 of the chamber 2 by a tube. The vacuum extractor 8 includes a valve 81 and a pump 85. The valve 81 and the pump 85 are configured to adjust the vacuum within the capacity space 4 of the chamber 2. For example, the vacuum extractor 8 can control the vacuum of the capacity space 4 at 5×10⁻³ torr. Or 5×10⁻⁵ torr by implementing with turbo pump. It should be noted that the substrate surface is modified at vacuum environment and heating condition to avoid oxidizing the substrate surface and gas out the organic materials on the surface or achieve the polarization of the substrate surface at very fast speed.

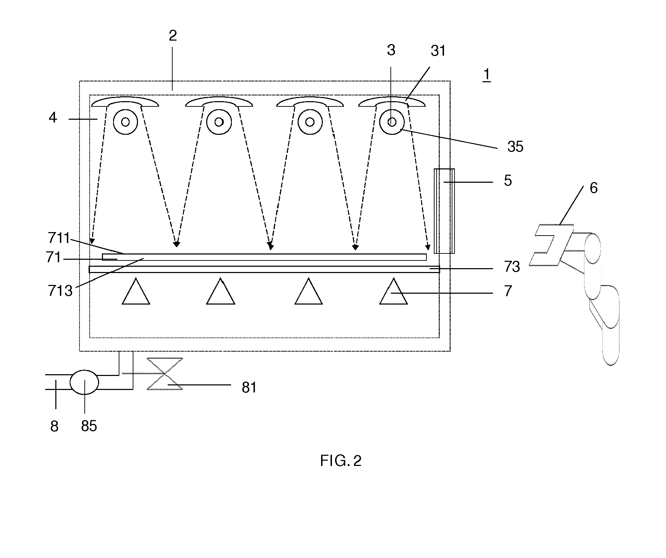

Please refer to FIG. 2, which is a view illustrating an operation of the substrate surface treatment equipment in the present invention. As shown in FIG. 2, when a substrate 71 ready to do a washing or modifying process is clipped by a robot arm 6 of the substrate surface treatment equipment 1 and the substrate surface treatment equipment 1 is controlled to open the gate 5. When the gate 5 is opened, the robot arm 6 moves the substrate 71 to the chamber 2 from the external space of the equipment 1 and puts the substrates 71 on the blackbody irradiation board 73. Then, the robot arm 6 is moved to the external space from the chamber 2 and the gate 5 is closed. The pressure of the chamber 2 is the same as the pressure of outer atmosphere. The vacuum extractor 8 is doing a vacuum extracting process. When the vacuum degree of the chamber 2 is at 5×10⁻³ torr and the chamber 2 is maintained at the certain vacuum degree. The substrate 71 can be a metal substrate, a metal flexible substrate, an organic substrate, an organic flexible substrate or a glass substrate. Obviously, the material of the substrate 71 is not limited in the present invention.

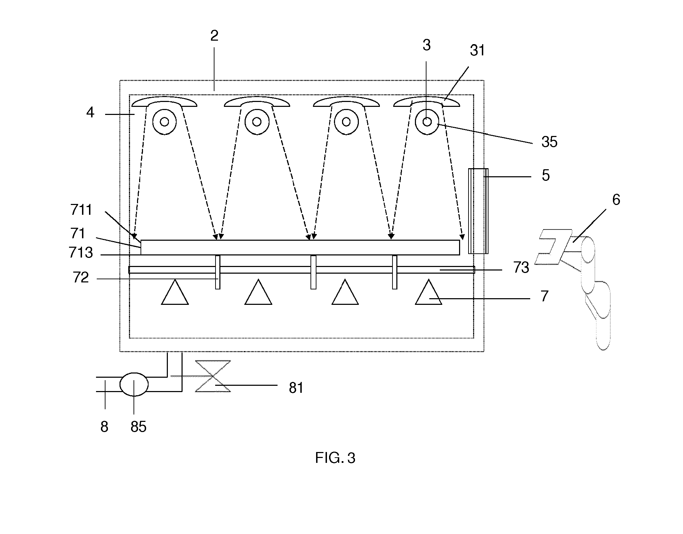

Now, please still refer to FIG. 2, when a substrate 71 (a glass substrate used as an example in the present invention) is disposed on the blackbody irradiation board 73 and the vacuum degree of the chamber 2 in the substrate surface treatment equipment 1 is at 5×10⁻³ torr. At this moment, the surface 711 of the substrate 71 is faced to ultraviolet lamp 3 at the top end of the chamber 2 and includes a distance between the substrate 71 and the ultraviolet lamp 3. The bottom surface 713 of the substrate 71 is directly contact with the blackbody irradiation board 73 or the bottom surface 713 of the substrate 71 can be disposed on a truss 72 (as shown in FIG. 3). The bottom surface 713 of the substrate 71 is not directly contacted with the blackbody irradiation board 73 and a distance exists therebetween. The truss 72 is disposed in the surrounding area of the infrared heating element 7. In one embodiment, when the bottom surface 713 of the substrate 71 is not directly contacted with the blackbody irradiation board 73 and a distance exists therebetween, the distance between the bottom surface 713 of the substrate 71 and the blackbody irradiation board 73 is smaller than the distance between the top surface 711 of the substrate 71 and the ultraviolet lamp 3. The distance described above is not limited herein too. In the following description of the embodiment, the bottom surface 713 of the substrate 71 is directly contacted with the blackbody irradiation board 73.

Subsequently, the infrared heating element 7 is controlled to heat and the infrared heating element 7 can heat to a predetermined temperature precisely in a short time and the temperature is maintained in a predetermined range. Because the blackbody irradiation board 73 is disposed on the infrared heating element 7, the blackbody irradiation board 73 is warm up during the heating process of the infrared heating element 7. When the infrared heating element 7 starts to heat the blackbody irradiation board 73, the blackbody irradiation board 73 will start to generate irradiation. For example, such as blackbody irradiation theory, when the blackbody irradiation board 73 is heated up to 350°C, heat radiation of the far infrared rays is generated. Therefore, the far infrared rays irradiated by the blackbody irradiation board 73 will heat the bottom surface 713 of the substrate 71. Because the blackbody irradiation board 73 can generate far infrared rays evenly, the bottom surface 713 of the substrate 73 is evenly heated. When under 350°C, the blackbody irradiation board made by carbon composites or graphite also includes a better heat irradiation efficiency to provide a faster and even heating efficiency than normal metals. At this time, the ultraviolet lamps can be optionally turned on, and the excimer ultraviolet rays are irradiated on the top surface 711. For example, the ultraviolet lamps will irradiate light source with 200nm wavelength. Therefore, when the top surface 711 of the substrate 71 within the chamber 2 includes water and volatile organic compounds (VOC) and the blackbody irradiation board 73 is heated by the infrared heating element 7 to generate infrared rays to heat the substrate 71, the water can be eliminated on the top surface 711 of the substrate 71 to be vapor. At this moment, the top surface 711 of the substrate 71 is irradiated by the ultraviolet lamp 3, the VOCs on the top surface 711 of the substrate 71 is activated or decomposed. By gasifying the organic compounds on the top surface 711 of the substrate 71, the VOCs can become gas to be eliminated. At final, the vacuum extractor 8 is used to make the chamber 2 in a vacuum status to increase the speed that the organic compounds are become gas. Subsequently, the gas is released to the outer space of the chamber 2 by the vacuum extractor 8. Therefore, the water and pollutions with VOCs can be eliminated on the top surface 711 of the substrate 71. After the pollution is eliminated on the surface 711 of the substrate, the clean condition on the surface of the substrate 71 is determined to be at a range of 5∼30° contact angles (for example: when pure water is dropped on the surface of the substrate 71 to measure the contact angle between the surface of the substrate 71 and water). The value is measured to include small contact angle, and the clean condition on the surface is better so as to increase the yield rate in the following processes. Obviously, the feature of the present invention is for the blackbody irradiation board 73 to evenly heat the substrate 71 to decrease the bonding force in the VOCs or interrupt the VOCs bond. After the ultraviolet lamps 3 irradiate on the organic compounds, the organic compounds are decomposed quickly to achieve the purpose of cleaning the substrate 71. Especially when the substrate 71 is a macromolecular polymer substrate, the surface of the macromolecular polymer is cleaned and becomes a polarity surface. If the molecule bond on the surface of the macromolecular polymer is interrupted, it is easy to generate static electricity. For example, the substrate is irradiated by the ultraviolet rays to become hydrogen radical or hydrogen and oxygen radical. The hydrophilic radicals, such as OH, COOH or CHO, are formed on the surface of the substrate 71 to form a polarity surface with good contact condition to increase the adhesion of the macromolecular polymer substrate in the following processes.

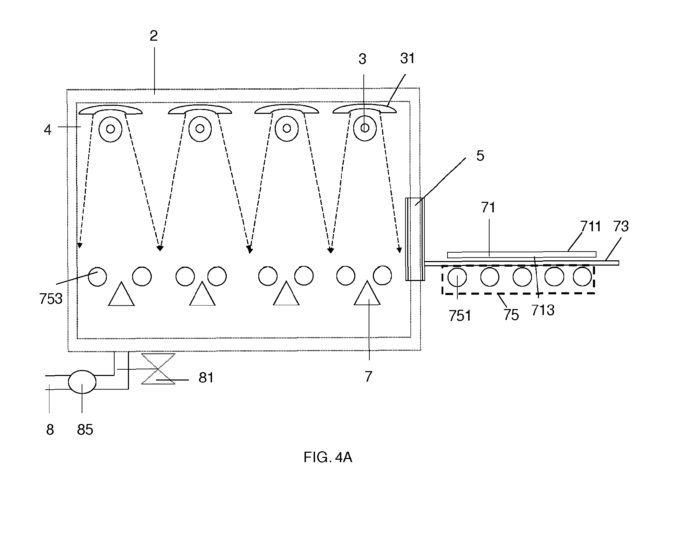

Now, please refer to FIG. 4A, which is a view illustrating another embodiment of the substrate surface treatment equipment in the present invention. As shown in FIG. 4A, the substrate surface treatment equipment 1 in the present invention includes a chambers 2, a gate 5 and at least one ultraviolet lamp 3. The chamber 2 includes a capacity space 4. The gate 5 is disposed at one side of the chamber 2 and the capacity space 4 within the chamber 2 can contact with outer atmosphere when the gate 5 is opened. The ultraviolet lamp 3 is disposed within the capacity space 4 and close to the top end of the chamber 2. The light source of the ultraviolet lamp 3 is made by an Excimer Ultraviolet. The ultraviolet lamp 3 is covered by a quartz tube 35 and the quartz tube 35 is covered by a reflected shield 31 with curved surface. Therefore, the ultraviolet rays can be evenly irradiated to the bottom end 23 of the chamber 2. An infrared heating element 7 is disposed within the capacity space 4 and close to the bottom end of the chamber 4. Therefore, a manufacturing space is formed between the ultraviolet lamp 3 and the infrared heating element 7. The infrared heating element 7 is a rapid thermal processing (RTP) apparatus and can exactly increase the temperature to a predetermined temperature in a very short time and control the temperature to keep the temperature in a predetermined range. A transportation apparatus 75 is made by a plurality of rolling wheels and the rolling wheels of the transportation apparatus 75 is operated with the rolling wheels 753 within the chamber 2 for moving the substrate 71 from the outer space of the chamber 2 to the inner space of the chamber 2 or from the inner space of the chamber 2 to the outer space of the chamber 2. The installation of the transportation apparatus 75 is accordance with the transportation of the substrate. The transportation apparatus 75 is disposed on the top of the infrared heating element 7. In accordance with proper installation, the rolling wheels 751 of the transportation apparatus 75 will not affect the heating path of the infrared heating element 7. A vacuum extractor 8 is disposed in outer space of the chamber 2 and connected to the capacity space 4 of the chamber 2 by a tube. The vacuum extractor 8 includes a valve 81 and a pump 85. The valve 81 and the pump 85 are configured to adjust the vacuum within the capacity space 4 of the chamber 2. For example, the vacuum extractor 8 can control the vacuum of the capacity space 4 at 5×10-3 torr. In the present embodiment, a blackbody irradiation board 73 is disposed on the rolling wheels within the chamber 2. Then, the substrate 71 (as a glass substrate implemented in the present embodiment) is disposed on the blackbody irradiation board 73 and the blackbody irradiation board 73 is made by graphite or carbon composite materials. Besides, the blackbody irradiation board 73 can be optionally formed by a metal board covered with a blackbody irradiation material and the black irradiation material is made by graphite or carbon composite materials.

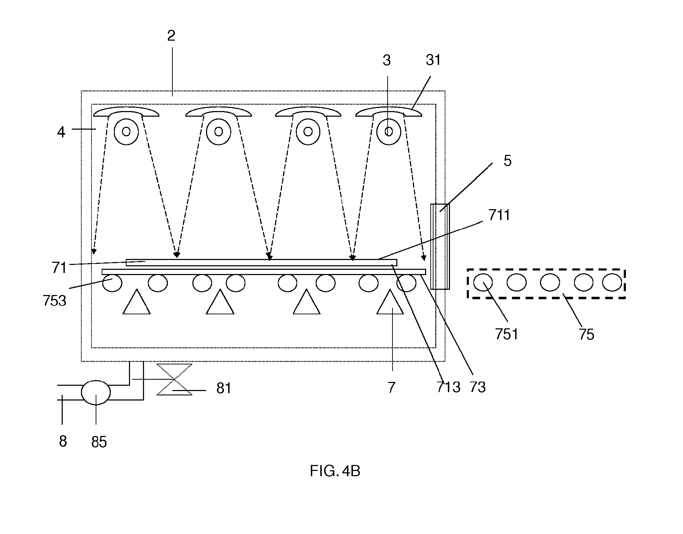

Now please refer to FIG. 4B, which is a view illustrating an operation of the substrate surface treatment equipment in the present invention. As shown in FIG. 4B, when the gate 5 is opened and the rolling wheels within the chamber 2 are controlled to do the transportation, the blackboard irradiation board 73 and the substrate 71 are moved to the gate 5 and then moved to the inner space of the chamber 2 by the rolling wheels 751 of the transportation apparatus 75. Then, the gate 5 is closed, and the pressure of the chamber 2 is the same as the pressure of outer atmosphere. The vacuum extractor 8 is doing a vacuum extracting process. When the vacuum degree of the chamber 2 is at 5×10⁻³ torr and the chamber 2 is maintained at the certain vacuum degree. The substrate 71 can be a metal substrate, a metal flexible substrate, an organic substrate, an organic flexible substrate or a glass substrate. Obviously, the material of the substrate 71 is not limited in the present invention. Subsequently, the infrared heating element 7within the chamber 2 heats the blackbody irradiation board 73. Before the temperature of the blackbody irradiation board 73 is reached to 350°C, the high thermal conductive efficiency of the blackbody irradiation board 73 can evenly increase the heat on the substrate 71. When the temperature of the blackbody irradiation board 73 is more than 350°C, the blackbody irradiation board 73 will irradiate the heat irradiation of the far infrared rays so as to heat the bottom of the object on the blackbody irradiation board 73. In addition, the top surface 711 of the substrate 71 is irradiated by the ultraviolet lamp 3 at the same time. When the VOCs with water and chemical pollution are existed on the top surface 711 of the substrate 71, the water on the top surface 711 of the substrate 71 can be eliminated and the water is gasified to be vapor. When the ultraviolet lamps is irradiated to the top surface 711 of the substrate 71, the VOCs on the top surface 711 of the substrate 71 is activated or composited by the ultraviolet rays. The organic compounds on the top surface 711 of the substrate 71 are heated and the VOCs are gasified to be eliminated. Subsequently, the vacuum extractor 8 is used to make the chamber 2 in a vacuum status to increase the speed that the organic compounds are become gas. The gas is released to the outer space of the chamber 2 by the vacuum extractor 8. At final, when the gate 5 is opened, the substrate 71 and the blackbody irradiation board 73 are moved to outer space of the chamber 2. After the pollution is eliminated on the surface 711 of the substrate, the clean condition on the surface of the substrate 71 is determined to be at a range of 5∼30° contact angles (for example: when pure water is dropped on the surface of the substrate 71 to measure the contact angle between the surface of the substrate 71 and water). The value is measured to include small contact angle, and the clean condition on the surface is better so as to increase the yield rate in the following processes.

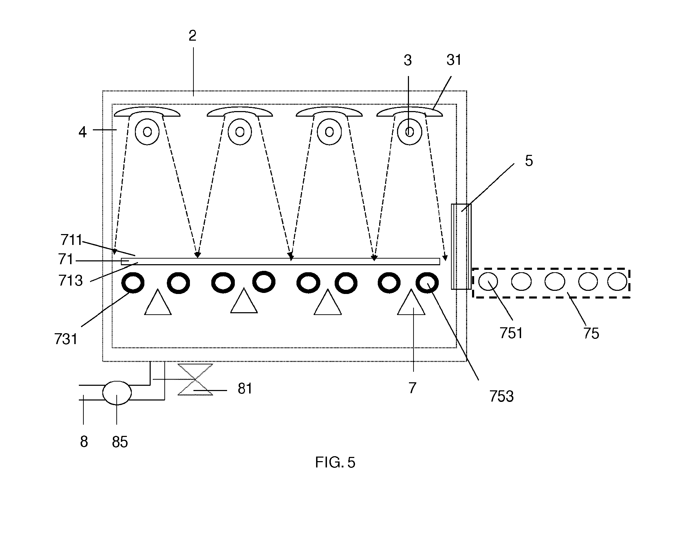

Now, please refer to FIG. 5, which is another embodiment of the substrate surface treatment equipment in the present invention. As shown in FIG. 5, the substrate surface treatment equipment 1 also includes a transportation apparatus 75 in the present embodiment. The rolling wheels 751 of the transportation apparatus 75 is covered with a blackbody irradiation material 731 and the black body irradiation material 731 is made by graphite or carbon composite materials. The rolling wheels 751 with blackbody irradiation material 731 replace the previous blackbody irradiation board 73. Obviously, the blackbody irradiation 73 is not required in the present embodiment. Because the rest of the components in the present embodiment are the same as those in the previous embodiment, the detail description thereof is omitted herein.

During operation, the substrate 71 is moved to the inner space of the chamber 2 by the rolling wheels 753 covered with the blackbody irradiation material 731 and the gate 5 is closed. Now the pressure within the chamber 2 is the same as the pressure in the outer atmosphere and the vacuum extractor 8 is doing a vacuum extracting process. When the vacuum degree within the chamber 2 is at 5×10⁻³ torr, the inter space of the chamber 2 is maintained in a certain vacuum degree. The substrate 71 can be a metal substrate, a metal flexible substrate, an organic substrate, an organic flexible substrate or a glass substrate. Obviously, the material of the substrate 71 is not limited in the present invention. Subsequently, the infrared heating element 7within the chamber 2 heats the blackbody irradiation material 731. Before the temperature of the blackbody irradiation material 731 is reached to 350°C, the high thermal conductive efficiency of the blackbody irradiation material 731 can evenly increase the heat on the substrate 71. When the temperature of the blackbody irradiation material 731 is more than 350°C, the blackbody irradiation material 731 will irradiate the heat irradiation of the far infrared rays so as to heat the bottom surface 713 of the substrate 71 on the rolling wheels 753. In addition, the top surface 711 of the substrate 71 is irradiated by the ultraviolet lamp 3 at the same time. When the VOCs with water and chemical pollution are existed on the top surface 711 of the substrate 71, the blackbody irradiation material 731 is heated by the infrared heating element 7 to generate infrared rays to heat the substrate. The water on the top surface 711 of the substrate 71 can be eliminated and the water is gasified to be vapor. When the ultraviolet lamps 7 is irradiated to the top surface 711 of the substrate 71, the VOCs on the top surface 711 of the substrate 71 is activated or composited by the ultraviolet rays. The organic compounds on the top surface 711 of the substrate 71 are heated and the VOCs are gasified to be eliminated. Subsequently, the vacuum extractor 8 is used to make the chamber 2 in a vacuum status to increase the speed that the organic compounds are become gas. The gas is released to the outer space of the chamber 2 by the vacuum extractor 8. At final, when the gate 5 is opened, the substrate 71 and the blackbody irradiation board 73 are moved to outer space of the chamber 2.

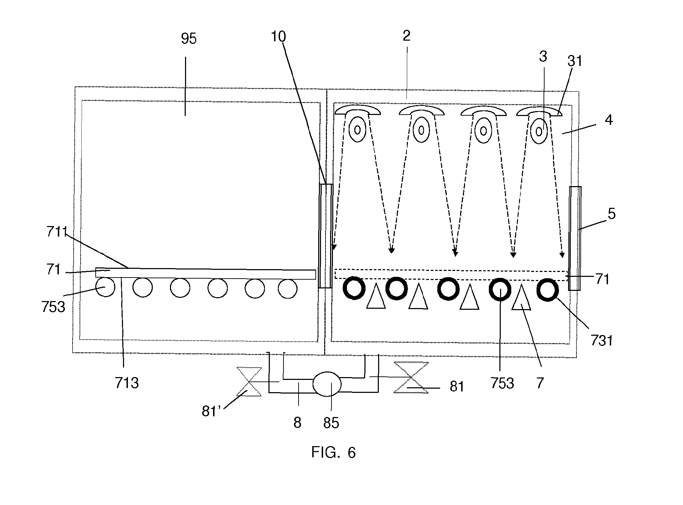

Now please refer to FIG. 6, which is a view illustrating a vacuum thin film deposition system in the present invention. As shown in FIG. 6, the vacuum thin film deposition system is made by a substrate surface treatment equipment 1 connected to a vacuum thin film deposition apparatus 95. For example, the vacuum thin film deposition apparatus 95 is disposed close to and connected to the substrate surface treatment equipment 1 by a connecting gate 10. The vacuum thin film deposition apparatus 95 includes a plurality of rolling wheels 757 disposed therein and is connected to a vacuum extractor 8 with a valve 81'. In the working procedure, the gate 5 is opened and the substrate 71, which is ready to wash or modify, is moved to the inner space of the chamber 2 by the external rolling wheels 751 (a metal substrate is used in the present embodiment and the substrate material can be metal plate substrate, metal flexible substrate and so on, and it is not limited to the material of the substrate 71 in the present invention).

Now, the rolling wheel 753 covered with blackbody irradiation material 731 is moved to the inner space of the chamber 2 (the present chapter is described in accordance with the embodiment in FIG. 5, but the substrate surface treatment equipment is not limited to be the embodiment in FIG. 4A or FIG. 5). Subsequently, the gate 5 is controlled to be closed and the pressure within the chamber 2 is the same as the pressure in the outer atmosphere. The vacuum extractor 8 is doing a vacuum extracting process. When the vacuum degree within the chamber 2 is at 5×10⁻³ torr, the inter space of the chamber 2 is maintained in a certain vacuum degree. Subsequently, the infrared heating element 7 within the chamber 2 heats the blackbody irradiation material 731. Before the temperature of the blackbody irradiation material 731 is reached to 350°C, the high thermal conductive efficiency of the blackbody irradiation material 731 can evenly increase the heat on the substrate 71. When the temperature of the blackbody irradiation material 731 is more than 350°C, the blackbody irradiation material 731 will irradiate the heat irradiation of the far infrared rays so as to heat the bottom surface of the substrate 71 on the rolling wheels 753. In addition, the top surface 711 of the substrate 71 is irradiated by the ultraviolet lamp 3 at the same time. When the VOCs with water and chemical pollution are existed on the top surface 711 of the substrate 71, the blackbody irradiation material 731 is heated by the infrared heating element 7 to generate infrared rays to heat the substrate. The water on the top surface 711 of the substrate 71 can be eliminated and the water is gasified to be vapor. When the ultraviolet lamps 7 is irradiated to the top surface 711 of the substrate 71, the VOCs on the top surface 711 of the substrate 71 is activated or composited by the ultraviolet rays. The organic compounds on the top surface 711 of the substrate 71 are heated and the VOCs are gasified to be eliminated. Subsequently, the vacuum extractor 8 is used to make the chamber 2 in a vacuum status to increase the speed that the organic compounds are become gas. The gas is released to the outer space of the chamber 2 by the vacuum extractor 8. Therefore, the water and chemical pollution with VOCs can be eliminated on the top surface 711 of the substrate 71.

Moreover, after the substrate 71 is treated by the substrate surface treatment equipment 1, the original surface with lower boding property and adhesive property is enhanced. The substrate 71 is moved to the vacuum thin film deposition apparatus 95 by the rolling wheels 753. The vacuum thin film deposition apparatus 95 is doing a vacuum process by the vacuum extractor 8. When the vacuum degree of the vacuum thin film deposition apparatus 95 is at 5×10⁻³ torr, the vacuum thin film deposition apparatus 95 is maintained in a certain vacuum degree to do the thin film deposition. For example, the silica generated within the vacuum thin film deposition apparatus 95 is deposited on the surface of the substrate because of the increasing of the boding property. The method described above can be operated in the apparatus of the unmanned factory and the serial operations of the vacuum thin film deposition are executed after the surface modifying.

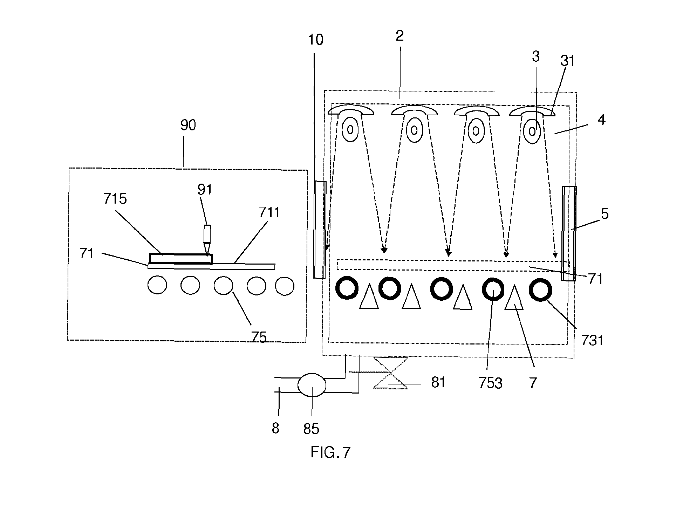

Now please refer to FIG. 7, which is a view illustrating the substrate surface coating system in the present invention. As shown in FIG. 7, the substrate surface coating system in the present invention is made by a substrate surface treatment 1 connected to a substrate surface coating apparatus 90. After the substrate 71 is treated by the substrate surface treatment equipment 1, the bonding property and the adhesive property of the surface of the substrate 71 is enhanced, the boding property of the surface of the substrate 71 is greatly increased. Therefore, when the gate 10 of the substrate surface treatment equipment 1 is opened, the substrate 1 is moved to the coating apparatus 90, such as a colloid suspension coating apparatus. Now, a long and narrow colloid suspension spray nozzle 91 is moved on the top surface 711 of the substrate 71 to form a colloid suspension coating layer 715 on the top surface 711 of the substrate 71. Because the surface of the substrate is treated, the colloid suspension coating layer 715 is tightly stuck on the top surface 711 of the substrate 71 instead of unfastening and dropping. The method described above can be operated in the apparatus of the unmanned factory and the serial operations of the colloid suspension coating are executed after the surface treatment. The method is suitable for coating a nano particle colloid suspension coating, such as Copper Indium Gallium Selenide (CIGS) or Copper Zinc Tin Sulfide (CZTS), to manufacture the CIGS or CZTS thin film solar battery.

## Claims

1. A substrate surface treatment equipment, comprising:
a chamber, and an inner space thereof includes a top end and a bottom end, and the top end is opposite to the bottom end and a containing space is formed between the top end and the bottom end;
at least one ultraviolet (UV) lamp disposed on a bottom of the top end;
an infrared heating element disposed on a top of the bottom end; and
a blackbody irradiation board disposed within the containing space of the chamber and disposed between the UV lamp and the infrared heating element.

2. The substrate surface treatment equipment according to claim 1, wherein the UV lamp is an excimer UV light source.

3. The substrate surface treatment equipment according to claim 1, wherein the UV lamp is covered by a quartz tube and a curved reflective shield is disposed outside of the quartz tube.

4. The substrate surface treatment equipment according to claim 1 further comprising a truss disposed a surrounding area of the infrared heating element.

5. The substrate surface treatment equipment according to claim 1, wherein the chamber further includes a transportation apparatus and the transportation is made by a plurality of rolling wheels and disposed a surrounding area of the infrared heating element.

6. The substrate surface treatment equipment according to claim 1, wherein the substrate surface treatment equipment is further connected to a colloid suspension coating system or a vacuum deposition system to be an apparatus.

7. A substrate surface treatment equipment, comprising:
a chamber, and an inner space thereof includes a top end and a bottom end, and the top end is opposite to the bottom end and a containing space is formed between the top end and the bottom end;
at least one ultraviolet (UV) lamp disposed on a bottom of the top end;
an infrared heating element disposed on a top of the bottom end; and
a plurality of blackbody irradiation components disposed within the containing space of the chamber and disposed between the UV lamp and the infrared heating element;
wherein the blackbody irradiation components are made by a plurality of rolling wheels and a blackbody irradiation material covered on outer surface of the rolling wheels.

8. The substrate surface treatment equipment according to claim 7, wherein the blackbody irradiation material is made by graphite or carbon composite materials.

9. A vacuum thin film deposition system is made by a substrate surface treatment equipment connecting to a vacuum thin film deposition apparatus, wherein the substrate surface treatment equipment comprises:
a chamber, and an inner space thereof includes a top end and a bottom end, and the top end is opposite to the bottom end and a containing space is formed between the top end and the bottom end;
at least one ultraviolet (UV) lamp disposed on a bottom of the top end;
an infrared heating element disposed on a top of the bottom end; and
a blackbody irradiation board disposed within the containing space of the chamber and disposed between the UV lamp and the infrared heating element.

10. The vacuum thin film deposition system according to claim 1 or 9, wherein the blackbody irradiation board is made by graphite or carbon composite materials.

11. The vacuum thin film deposition system according to claim 1, 7 or 9, wherein the blackbody irradiation board is made by a metal board and a blackbody irradiation material covered the metal board.

12. A substrate surface coating system is made by a substrate surface treatment equipment connecting to a substrate surface coating apparatus, wherein the substrate surface treatment equipment comprises:
a chamber, and an inner space thereof includes a top end and a bottom end, and the top end is opposite to the bottom end and a containing space is formed between the top end and the bottom end;
at least one ultraviolet (UV) lamp disposed on a bottom of the top end;
an infrared heating element disposed on a top of the bottom end; and
a blackbody irradiation board disposed within the containing space of the chamber and disposed between the UV lamp and the infrared heating element.

13. The substrate surface coating system according to claim 1, 7, 9 or 12 further comprising a vacuum extractor connected to the chamber.
